# EUROPEAN PATENT APPLICATION

(11) **EP 3 358 924 A1**
(43) Date of publication of application: **08.08.2018**
(21) Application number: 18154325.7
(22) Date of filing: 31.01.2018
(51) Int. Cl.: H05K 7/20

(54) **APPARATUS PROVIDING A THERMAL INTERFACE**

(30) Priority: 01.02.2017 US 201762453026 P
(71) Applicant: THOMSON LICENSING, 92130 Issy les Moulineaux (FR)
(72) Inventor: RITTER, Darin, Indianapolis, IN Indiana 46290 (US); CARPENTER, Joseph, Indianapolis, IN Indiana 46290 (US); DERNIER, William, Indianapolis, IN Indiana 46290 (US); HUNT, Mickey, Indianapolis, IN Indiana 46290 (US)
(74) Representative: Huchet, Anne

(57) **Abstract**

Apparatus providing a thermal interface includes a printed circuit board (120) configured to be thermally coupled to a component (110; 210) to dissipate heat from the printed circuit board. The printed circuit board includes a surface (170) to be thermally coupled to a surface (160) of the component with a thermally conductive substance (130) such as a thermal putty included in a region (320) between the surface of the printed circuit board and the surface of the component. The surface of the printed circuit board includes a pattern of features (330) configured to decrease migration of the thermal putty out of the region.

## Description

### TECHNICAL FIELD

The present principles relate generally to providing a thermally conductive interface for heat management in electronic equipment.

### BACKGROUND

Electronic equipment generates heat when operating and the heat may adversely affect the operation and the reliability of the equipment. Typically, design of such equipment must include components to dissipate excessive heat and maintain desired operating temperatures of the equipment. In particular, active devices such as integrated circuits and other power-consuming components both active and passive such as power transistors, power diodes and power resistors included in electronic equipment may generate heat that requires adding features to the equipment to properly dissipate undesirable heat.

Features added for heat dissipation may include components such as heat sinks and heat spreaders. Such components intended to dissipate heat from a device such as an integrated circuit (IC) may be thermally coupled to the device or to a printed circuit board (PCB) on which the device is mounted to ensure efficient conduction of heat from the device or the PCB to the heat-dissipation component. Achieving thermal coupling typically involves positioning a surface of the heat dissipation component in close proximity to a surface of the device, e.g., the top surface of an IC, or a surface of the PCB.

Despite the surfaces being in close proximity when the heat dissipation component is initially positioned during production, an air gap or space may exist initially between the surfaces due to production tolerances (e.g., to allow space for component movement). Even if the surfaces are touching initially, a gap or space may subsequently form due to surface irregularities, component aging, movement of the equipment, or other movement of the components, e.g., due to repeated cycles of heating and cooling of the apparatus. Any such air gaps significantly reduce the efficiency of the thermal interface between the surfaces, i.e., surface of the heat dissipation component and the surface of the device or PCB.

To minimize such air gaps and increase the thermal efficiency of the interface to an acceptable level, a high-viscosity thermally conductive substance such as a thermal putty may be placed between the surfaces prior to positioning of the passive heat dissipation component. As the heat dissipation component is moved into close proximity to the surface from which the heat is to be removed, the putty is compressed and spreads between the surfaces to fill any gaps that exist and create a thermally efficient interface.

The described thermal interface functions well for equipment, e.g., a digital set top box used for cable television or digital satellite television reception, that typically has been rectangular in shape, installed in a horizontal position flat on a shelf and moved infrequently or not at all. In such conventional installations, the PCBs inside the equipment would usually be in a horizontal position when the equipment was installed. Active components and the heat dissipation components coupled thereto were mounted flat on the PCBs and were also oriented horizontally as were the thermal interfaces between the heat dissipation components and surfaces of the PCBs and/or heat-generating devices. However, modern electronic equipment may have shapes other than rectangular or be relocated frequently or installed in an unconventional orientation. For example, today rectangular set top boxes may be positioned on edge rather than flat or may have unusual configurations such as a pyramid to create a particular look or aesthetic effect. Printed circuit boards in a rectangular box that is installed on edge or in a box having a configuration other than rectangular may be oriented vertically or in an orientation other than horizontal when the equipment is in operation. As a result, the thermal interfaces between the heat dissipation components and surfaces of the PCBs and/or devices mounted on the boards may be oriented vertically or have some orientation other than horizontal.

A thermal interface having an orientation other than horizontal may result in gravity causing a thermal putty to flow out of the thermal interface. The potential for thermal putty to flow may be exacerbated by high temperature in the thermal interface and by movement of components, devices and/or PCBs due to vibration of the equipment, e.g., by movement or relocation of the equipment, and thermal cycling. A loss of thermal putty in a thermal interface may result causing reduced thermal efficiency in the interface and excessive heating of the equipment that could lead to premature device failure. In addition, a substance such as thermal putty flowing out of an interface might contaminate areas or components in the vicinity of the thermal interface and result in reduced performance, improper operation or failure of such nearby components or the equipment.

### SUMMARY

These and other drawbacks and disadvantages of the prior art are addressed by the present principles.

According to an aspect of the present principles, there is provided apparatus comprising a printed circuit board configured to be thermally coupled to a component to dissipate heat from the printed circuit board wherein the printed circuit board comprises a first surface having an area to be thermally coupled to a second surface of the component with a thermal putty included in a region between the area of the first surface and the second surface, and a pattern of features on a portion of the area of the first surface of the printed circuit board, wherein the features being configured to decrease migration of the thermal putty out of the region.

According to another aspect of the present principles, there is provided apparatus comprising a printed circuit board configured to be thermally coupled to a component to dissipate heat from the printed circuit board wherein the printed circuit board comprises a first surface including a first area to be thermally coupled to a second surface of the component using a thermally conductive substance included in a region between the first area of the first surface and the second surface of the component, and a raised second area in at least a portion of the first area of the first surface, wherein the raised second area comprises a third area configured for providing a target for application of the thermally conductive substance.

According to another aspect of the present principles, there is provided apparatus comprising a printed circuit board configured to be thermally coupled to a component to dissipate heat from the printed circuit board wherein the printed circuit board comprises a surface having an area configured to be thermally coupled to a surface of the component with a thermally conductive substance included in a region between the surface of the component and the surface of the printed circuit board, and a pattern of features on a portion of the area of the surface of the printed circuit board and configured to inhibit migration of the thermally conductive substance out of the region.

According to another aspect of the present principles, an exemplary embodiment of apparatus as described herein may include one or more of a thermally conductive substance comprising a thermal putty, a pattern of features comprising a feature centered in the portion of the surface of the printed circuit board and providing a target facilitating a procedure included in thermally coupling the surface of the component to the surface of the printed circuit board, the procedure comprises application of the thermal putty wherein the target comprises a target for application of the putty, and the component comprises one of a heat spreader and a heat sink.

According to another aspect of the present principles, there is provided a printed circuit board comprising a surface having an area configured to be thermally coupled to a surface of a component to dissipate heat from the printed circuit board with a thermally conductive substance included in a region between the area of the surface of the printed circuit board and the surface of the component, and a pattern of features included on a portion of the area of the surface of the printed circuit board and oriented to impede migration of the thermally conductive substance out of the region.

According to another aspect of the present principles, an exemplary embodiment of a printed circuit board as described herein may include one or more of a thermally conductive substance comprising a thermal putty, a pattern of features comprising a feature centered in the portion of the surface of the printed circuit board and providing a target facilitating a procedure included in thermally coupling a surface of a component to the surface of the printed circuit board, the procedure comprises application of the thermal putty, and the target comprises a target for application of the putty, and the component comprises one of a heat spreader and a heat sink.

According to another aspect of the present principles, there is provided apparatus comprising a printed circuit board configured to be thermally coupled to a component to dissipate heat from the printed circuit board wherein the printed circuit board comprises a surface including a region to be thermally coupled to a surface of the component using a thermally conductive substance included in at least a portion of the region and between the surface of the printed circuit board and the surface of the component; and a raised area in at least a portion of the region of the surface of the printed circuit board; wherein the raised area comprises a portion providing a target for application of the thermally conductive substance.

According to another aspect of the present principles, an exemplary embodiment of apparatus including a printed circuit board as described herein may include one or more of a thermally conductive substance comprising a thermal putty, a raised area further comprising a pattern of features on the surface of the printed circuit board configured to decrease migration of the thermal putty out of the region, the pattern of features comprises an arrangement of a plurality of ridges protruding from the surface of the printed circuit board, the plurality of ridges includes a plurality of copper traces on the surface of the printed circuit board and the arrangement comprises at least one of the plurality of ridges being positioned perpendicular to a direction of migration of the thermal putty, the arrangement of the plurality of ridges comprises a positioning of the plurality of ridges in at least one of a plurality of parallel ridges and a rectangular grid and a starburst and a spiral and a plurality of crossed ridges and a plurality of circles, the plurality of ridges occupies less than 50% of the surface area of the region, the plurality of ridges are formed in the region of the surface of the printed circuit board by one of screened and reflowed solder and wave applied solder, the plurality of ridges formed in the region of the printed circuit board are configured to increase a surface area of the region of the surface of the printed circuit board thermally coupled to the surface of the component, thereby improving a thermal conduction of the thermal coupling between the surface of the printed circuit board and the surface of the component, the component comprises one of a heat spreader and a heat sink, and the apparatus is included in an electronic device comprising one of a set top box, a gateway device, a router, a computer or a digital television.

According to another aspect of the present principles, there is provided an electronic device comprising a first surface having an area adapted to be thermally coupled to a second surface with a thermally conductive substance included in a region between the first surface and the second surface; and a pattern of features on a portion of the area of the first surface and configured to impede migration of the thermally conductive substance out of the region.

According to another aspect of the present principles, an exemplary embodiment of an electronic device as described herein may include one or more of the first surface comprises a surface of a printed circuit board included in the electronic device; and the second surface comprises a surface of a component included in the electronic device, wherein themal coupling of the first surface to the second surface dissipates heat from the printed circuit board to the component, the pattern of features comprises a feature centered in the portion of the surface of the printed circuit board and providing a target facilitating a procedure included in thermally coupling the second surface of the component to the surface of the printed circuit board, the thermally conductive substance comprises a thermal putty, and the procedure comprises application of the thermal putty, and the target comprises a target for application of the putty, the pattern of features includes a raised area in the portion of the area and protruding from the first surface into the region between the first surface and the second surface; wherein the raised area comprises a portion providing a target for application of the thermally conductive substance, the pattern of features comprises an arrangement of a plurality of ridges protruding from the surface of the printed circuit board into the region, the plurality of ridges includes a plurality of copper traces on the surface of the printed circuit board and the arrangement comprises at least one of the plurality of ridges being positioned perpendicular to a direction of migration of the thermal putty, the arrangement of the plurality of ridges comprises a positioning of the plurality of ridges in at least one of a plurality of parallel ridges and a rectangular grid and a starburst and a spiral and a plurality of crossed ridges and a plurality of circles, the plurality of ridges occupies less than 50% of the surface area of the region, the plurality of ridges are formed in the region of the surface of the printed circuit board by one of screened and reflowed solder and wave applied solder, the plurality of ridges formed in the region of the printed circuit board are configured to increase a surface area of the region of the surface of the printed circuit board thermally coupled to the surface of the component, thereby improving a thermal conduction of the thermal coupling between the surface of the printed circuit board and the surface of the component, the component comprises one of a heat spreader and a heat sink, the pattern of features may be configured for at least one of surrounding or encapsulating or enclosing or retaining the thermally conductive substance, and the electronic device may comprise one of a set top box, a gateway device, a router, a computer, and a digital television.

These and other aspects, features and advantages of the present principles will become apparent from the following detailed description of exemplary embodiments, which is to be read in connection with the accompanying drawings.

### BRIEF DESCRIPTION OF THE DRAWINGS

The present principles can be readily understood by considering the following detailed description in conjunction with the accompanying drawings wherein:
FIG. 1 is a diagram showing an exemplary thermal interface apparatus to which the present principles can be applied;
FIG. 2 is a diagram showing another exemplary thermal interface apparatus to which the present principles can be applied;
FIG. 3 is a diagram showing an apparatus in accordance with an exemplary embodiment of the present principles;
FIG. 4 is a diagram showing the exemplary embodiment shown in FIG. 3 and incorporating another aspect of the present principles;
FIG. 5A is a diagram showing the exemplary thermal interface apparatus illustrated in FIG. 1 incorporating the exemplary embodiment illustrated in FIG. 3 and FIG. 4;
FIG. 5B is a diagram showing the exemplary thermal interface apparatus illustrated in FIG. 2 incorporating the exemplary embodiment illustrated in FIG. 3 and FIG. 4;
FIG. 6 is a diagram showing a plurality of exemplary embodiments of aspects of the present principles; and
FIG. 7 is a diagram showing a plurality of various embodiments of aspects of the present principles.

It should be understood that the drawings are for purposes of illustrating exemplary aspects of the present principles and are not necessarily the only possible configurations for illustrating the present principles. To facilitate understanding, throughout the various figures like reference designators refer to the same or similar features.

### DETAILED DESCRIPTION

The present principles are directed to apparatus providing a thermal interface addressing problems such as those described above and, as will be apparent to one skilled in the art, may be applied to other situations. While one of ordinary skill in the art will readily contemplate various applications to which the present principles can be applied, the following description will focus on exemplary embodiments of the present principles applied to a printed circuit board (PCB) configured for coupling to a heat transfer component, e.g., a passive component such as a heat spreader, heat sink, etc., for removing heat from the PCB. One of ordinary skill in the art will readily contemplate various other embodiments of the present principles including, for example, a PCB configured for coupling to other heat transfer components, both active and passive, such as heat sinks, fins (structures to expand surface area), cavities (inverted fin structures), cold plates, forced air cooling (structures operating in conjunction with cooling fans), heat pipes and others. It will be readily apparent to one skilled in the art that excessive heat associated with a PCB may originate from various heat-generating devices mounted on the PCB such as an integrated circuit (IC), power transistors, power resistors, power supplies, etc., and create thermal transfer situations suitable for application of the present principles. As a specific example, a high-speed data processor IC packaged in a ball grid array (BGA) package mounted on a printed circuit board (PCB) may generate significant excess heat that is transferred to the PCB. Also, the present principles are applicable to thermal interfaces involving PCBs occurring in various types of electronic equipment including set-top boxes, gateway devices, routers, servers, computers, televisions, monitors, and others. It is to be appreciated that the preceding listing of potential applications of the present principles is merely illustrative and not exhaustive.

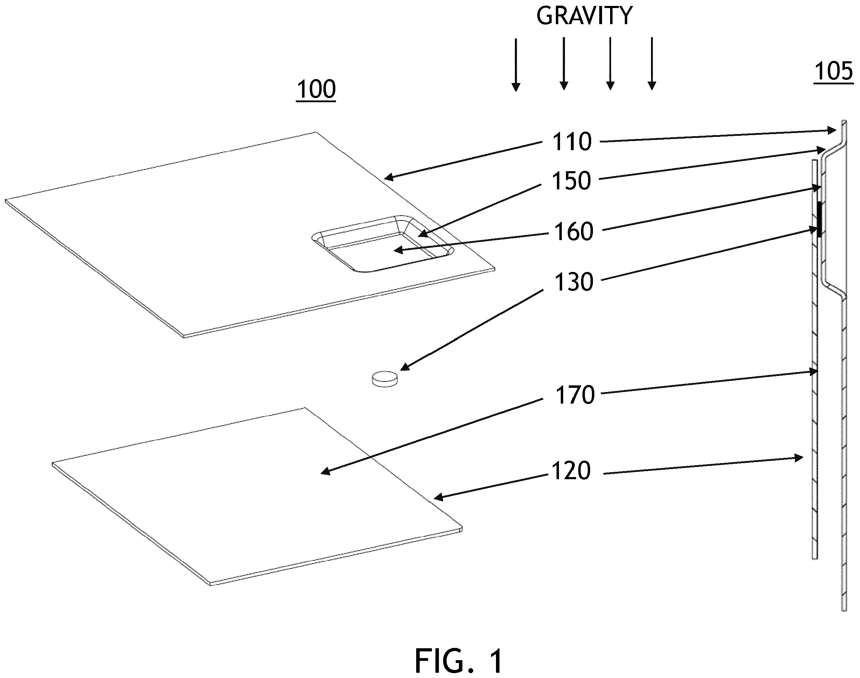

Referring now to Figure 1, an exemplary embodiment of a thermal interface suitable for application of the present principles is shown. The left side of Figure 1 illustrates an exploded perspective view 100 of aspects of the thermal interface prior to assembly of the interface. The right side of Figure 1 shows a side sectional view 105 illustrating a cross section of the assembled thermal interface. In more detail, Figure 1 shows a heat removal component 110 such as a heat spreader including a large planar area from which a portion 150 protrudes. Protrusion 150 is formed during manufacturing of heat spreader 110, e.g., by stamping or molding, and has a planar area, portion or region 160. Also shown in Figure 1, a printed circuit board (PCB) 120 has a surface 170. An area, portion or region of surface 170 of PCB 120 is configured to be thermally coupled to surface 160 of component 110 to facilitate removal of excess heat from PCB 120. During assembly of electronic equipment including the exemplary apparatus shown in Figure 1, heat spreader 110 is positioned to place surface 160 of heat spreader 110 in close proximity to an area of surface 170 of PCB 120. Before moving the component 110 and surface 160 into close proximity to surface 170, a small amount, e.g., a small pellet 130 in Figure 1, of a high-viscosity thermally conductive substance such as thermal putty is placed between surface 160 and the area of surface 170 intended to be thermally coupled to component 110. Movement of the two surfaces into close proximity during final production or assembly of the device, e.g., a digital set top box, causes the pellet to deform and fill at least a portion of the space or region between surfaces 160 and 170, thereby providing a thermally conductive interface enabling excess heat associated with PCB 120 to transfer efficiently to heat dissipating component 110.

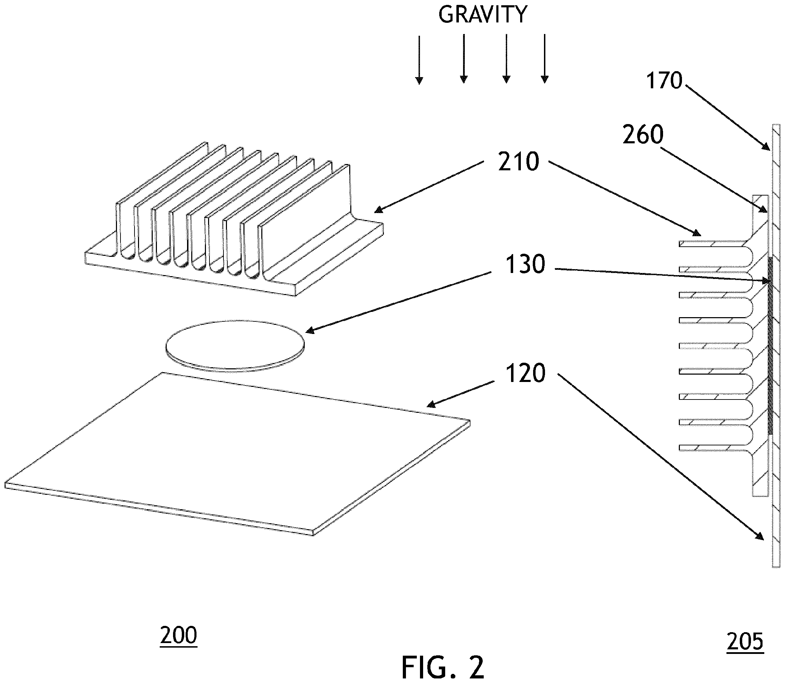

A second example of a thermal interface suitable for application of the present principles is shown in Figure 2. Figure 2 illustrates an embodiment similar to that shown in Figure 1, but involving a heat sink 210 rather than the heat spreader 110 shown in Figure 1. Other aspects of Figure 2 may be understood by referring to the preceding detailed explanation of Figure 1.

As described above, if PCB 120 and a heat dissipation component such as heat spreader 110 or heat sink 210 are oriented horizontally with respect to gravity as shown in Figure 1 or Figure 2, a thermal interface in the region between surface 160 or 260 and PCB 120 as shown in Figure 1 or Figure 2 is oriented horizontally and the force of gravity is in the direction shown in the figures, i.e., perpendicular to the horizontal plane of the thermal interface. As a result, the force of gravity operates to retain a thermally conductive substance such as high-viscosity thermal putty in place in the thermal interface region between surfaces 160 and 170, thereby enabling the thermal interface to operate as intended and facilitate efficient heat removal from PCB 120 to heat dissipating component 110 or 210. However, also as described above, if a thermal interface such as that illustrated in Figure 1 or Figure 2 is positioned in an orientation other than horizontal, effects such as gravity, vibration, high temperature, thermal cycling and others may cause a substance such as thermal putty 130 to flow or migrate within the area between surfaces 160 and 170 and, potentially, move out of the intended area for the putty into surrounding areas of the electronic equipment. Any such migration may cause a decrease of the heat transfer efficiency of a thermal interface and/or contamination of surrounding components, reduced reliability and failure of components and/or the electronic equipment.

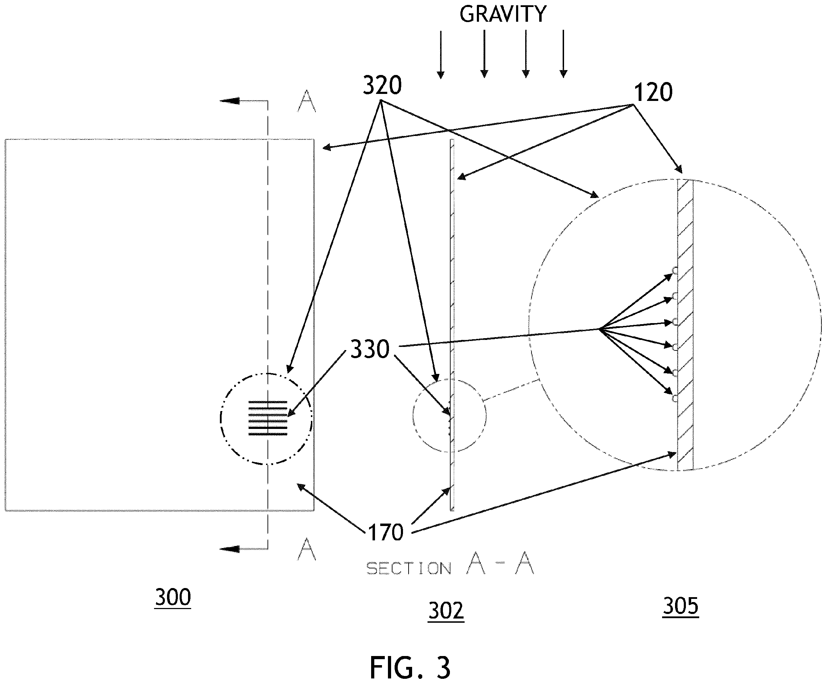

In accordance with the present principles, the described problem is addressed by thermal interface apparatus such as an exemplary embodiment shown in Figure 3. The left side of Figure 3 shows a top view 300 of a PCB 120 oriented on edge or vertically such that the force of gravity is along surface 170 of PCB 120 as shown in Figure 3. Surface 170 comprises a region or area 320 intended to be thermally coupled to a surface of a heat removal component such as surface 160 of heat spreader 110 of Figure 1 or surface 260 of heat sink 210 of Figure 2. Area 320 includes features 330 configured to decrease, reduce, inhibit or impede migration or movement of a thermally conductive substance such as thermal putty out of a thermal interface region formed when area 320 of PCB 120 is thermally coupled to a surface of a heat dissipation component.

As shown in Figure 3, an exemplary embodiment of features 330 comprises a raised area or features that protrude above or away from surface 170 such as the exemplary pattern of features comprising a plurality of raised parallel lines or traces 330 as illustrated in Figure 3. In the example of Figure 3, features 330 are configured to resist or inhibit potential migration of a thermal substance such as thermal putty. For example, Figure 3 illustratively shows features 330 oriented to be suitable for decreasing migration of a thermal substance along line A - A in view 200. That is, in the example of Figure 3, PCB 120 may be oriented such that line A - A is vertical or in an orientation other than horizontal. In such an orientation, gravity will act along line A - A as shown in Figure 3 and might increase likelihood that a thermally conductive substance such as a thermal putty will flow or migrate along line A - A and move out of a thermal interface formed in the region between area 320 of PCB 120 and a heat dissipation component such as heat spreader 110 or heat sink 210. However, in accordance with the present principles, the arrangement of features 330 is perpendicular to line A - A and protrude from surface 170 into the thermal interface region. As a result, features 330 are configured to impede or decrease movement or flow of a thermally conductive substance such as thermal putty out of a thermal interface. Sectional view 302 in the center of Figure 3 illustrates a side view of a slice through PCB 120 at line A-A in view 300 showing features 330 protruding beyond surface 170. View 305 on the right side of Figure 3 illustrates area 320 magnified to more clearly illustrate the exemplary embodiment of features 330 included or located in at least a portion of area 320 and comprising a plurality of ridges protruding above or beyond surface 170 of PCB 120.

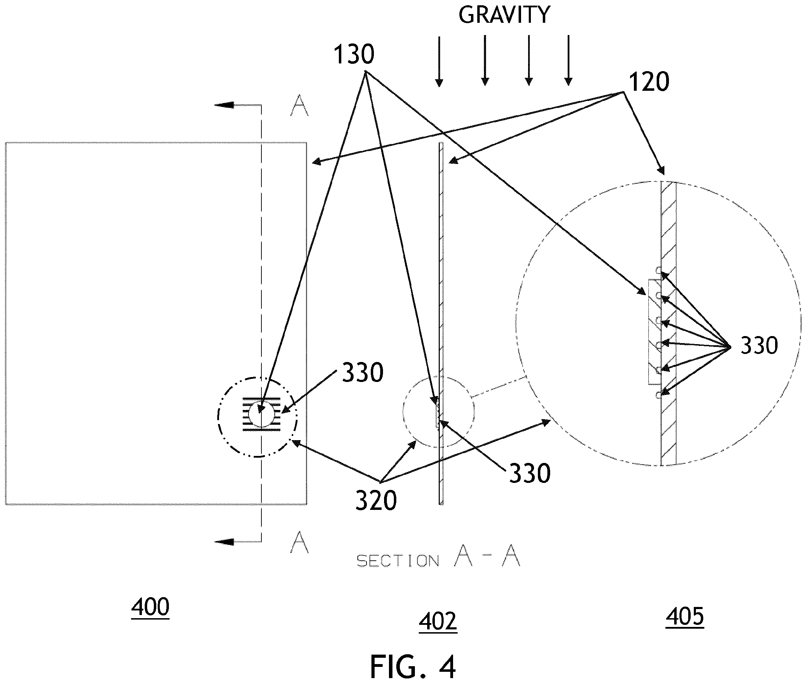

Figure 4 further illustrates the exemplary embodiment of Figure 3 in accordance with another aspect of the present principles. In Figure 4, top view 400, side view 402 and magnified view 405 correspond to views 300, 302 and 305 in Figure 3. In addition, Figure 4 illustrates a small amount or pellet 130 of a thermally conductive substance such as thermal putty positioned in an area 320 of PCB 120 intended to create a thermal interface, for example, with a heat dissipation component. As can be seen in magnified view 405 on the right side of Figure 4, the pellet of thermal putty is shown as having deformed or spread, e.g., as a result of being compressed between PCB 120 and a heat dissipation component, to cover a portion of area 320 including at least a portion of arrangement or pattern of features 330. In the exemplary embodiment shown in Figure 4, features 330 include a plurality of parallel ridges, lines or traces protruding from the surface of PCB 120 and interacting with thermally conductive substance 130. Features 330 are oriented perpendicular to the direction of gravity and, therefore, are configured such that the interaction of features 330 with the thermal putty operates for decreasing or impeding migration of, for example, thermal putty 130 along a line extending from the top to the bottom of views 400, 402 and 405.

Also in regard to Figure 4, certain configurations of features 330 as illustrated in Figure 4 may operate to retain or encapsulate the thermally conductive substance 130 by surrounding or enclosing the thermally conductive substance within features 330, thereby preventing or substantially preventing movement of the thermally conductive substance out of the thermal interface. For example, configurations 420 and 440 may surround or enclose the thermally conductive substance. For example, for a pattern such as pattern 420 wherein the lines shown in Figure 4 correspond to raised portions or ridges, the enclosed region formed by a raised region or ridge indicated by the lines at the perimeter of one of the rectangles in pattern 420, e.g., the outer perimeter of pattern 420, may surround or encapsulate the thermally conductive substance and retain the substance within the enclosed region. Similarly, one of the pairs of closely-spaced circles of pattern 440 may indicate a ridge or raised area that forms an enclosed region that may encapsulate and retain the substance, e.g., the outer pair of closely-spaced circles. Thus, the pattern of features may be configured for at least one of surrounding or encapsulating or enclosing or retaining the thermally conductive substance.

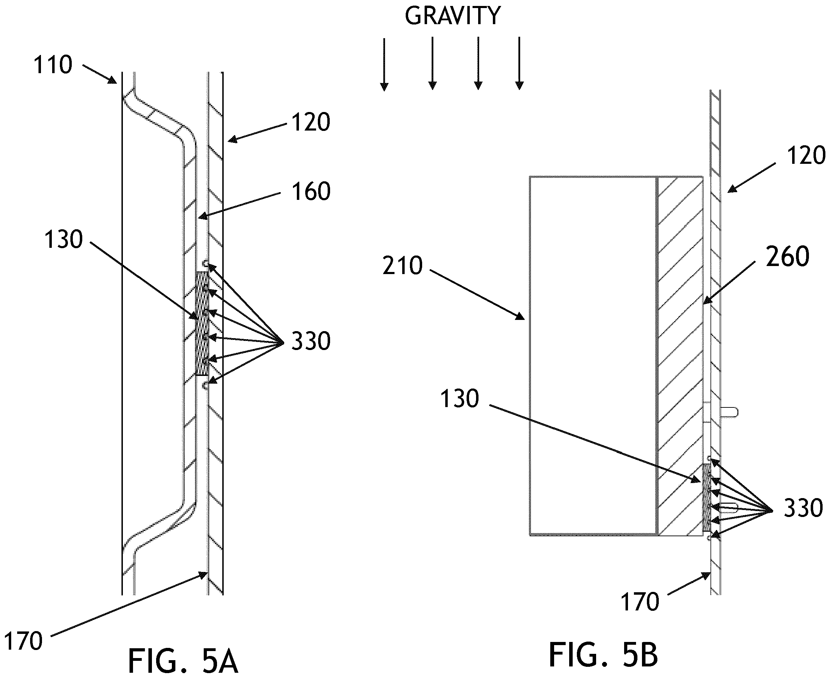

Figures 5A and 5B further illustrate aspects of the exemplary embodiment shown in Figures 3 and 4. In Figure 5A, a heat spreader 110 has a surface 160 shown in close proximity to surface 170 of PCB 120 with features 330 protruding from surface 170. Thermally conductive substance 130 is positioned in a region between surfaces 170 and 160 and over at least a portion of features 330 to form a thermal interface in the region between surfaces 160 and 170. In the example of Figure 5A, features 330 are oriented perpendicular to the direction of gravity. As a result, features 330 are configured to inhibit or impede migration of thermally conductive substance 130 out of the region between the surfaces. Figure 5B illustrates aspects of the present principles similar to those illustrated in Figure 5A except incorporating a heat sink 210 rather than heat spreader 110.

In accordance with another aspect of the present principles, features 330 may be formed, for example, by etching or otherwise forming copper traces on surface 170 of PCB 120 in a pattern such as the exemplary plurality of parallel lines shown in Figure 3 followed by one of screened and reflowed solder and wave applied solder to create a raised or protruding area or areas of PCB 120. Application of solder enables controlling the height of the raised portions, i.e., amount of solder increases or decreases the extent to which the features 330 protrude above or beyond surface 170. Increased height of the protruding features may be desirable, e.g., to increase the surface area within the thermal interface by adding the sidewall area of the protrusions, thereby increasing heat transfer efficiency of the thermal interface.

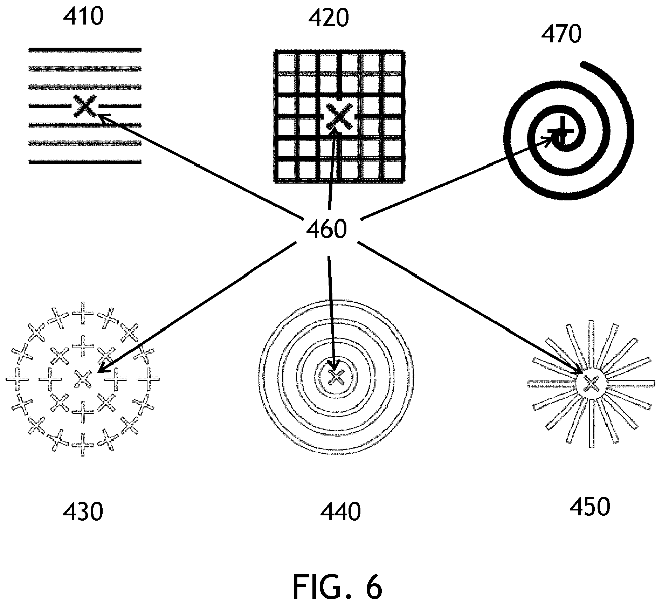

In accordance with another aspect of the present principles, an exemplary embodiment of features 330 illustrated as parallel ridges, lines or traces protruding above surface 170 of PCB 120 may be implemented in various other exemplary embodiments of the pattern of features 330 as shown in Figure 6. In Figure 6, the arrangement of features suitable for decreasing or impeding migration or flow of a thermally conductive substance such as thermal putty may take the form of a plurality of raised lines or traces that are parallel and perpendicular to an expected direction of flow or migration of the thermal putty as previously discussed and shown in Figures 3, 4 and 5. Such a pattern is also illustrated as pattern 410 in Figure 6. Other possible embodiments of the arrangement or pattern of features 330 may include raised or protruding ridges, portions or areas of PCB 120 arranged in a rectangular grid as shown in view 420 of Figure 6, or an arrangement of a plurality of crossed raised areas as shown in view 430 of Figure 6, or an arrangement of circular raised areas as shown in view 440 of Figure 6, or a starburst pattern of raised areas as shown in view 450 of Figure 6, or a spiral pattern of raised areas as shown in view 470 of Figure 6. As will be apparent to one skilled in the art, other patterns or arrangements of features not shown in Figure 6 are also possible and in accordance with the present principles. Also, the patterns shown may be combined in various ways to create other embodiments of arrangements or patterns of features in accordance with the present principles, e.g., a starburst in the center of one or more circles or a plurality of crosses combined with circles or combined with the rectangular grid or other patterns.

In accordance with another aspect of the present principles, improper positioning of a thermally conductive substance may occur when the substance is applied to a heat dissipation component prior to assembly of the component to a device for heat removal. For example, to ensure proper distribution of a substance such as a thermal putty in a thermal interface, the substance should be applied properly, e.g., approximately centered in a planar region of the PCB intended to form a thermal interface with a heat dissipation component. Proper positioning may occur in a factory environment using automated computer-controlled production equipment. However, outside of a factory, proper positioning may be problematic. For example, in a repair facility or when repairs are made in the field, e.g., a consumer's home, if equipment is disassembled such that existing thermal interfaces are separated or disassembled, e.g., a heat dissipation device is removed to access or replace a device coupled thereto, the thermally conductive substance must be reapplied before reassembly of the equipment. Improper positioning of the thermally conductive substance may occur in such a situation, e.g., not centered in the area of PCB intended to form the thermal interface. If so, the substance may fill only a portion of the intended thermal interface resulting in reduced efficiency of the thermal interface.

An aspect of the present principles comprises providing apparatus including a target to aid in proper positioning of a thermally conductive substance, e.g., a thermal putty. An exemplary embodiment of such apparatus comprises a PCB configured to be thermally coupled to a component to dissipate heat from the device. The PCB includes a first surface and the first surface includes a region or area to be thermally coupled to a surface of the component using a thermally conductive substance. The substance is to be included in at least a portion of the region and between the first surface and the surface of the heat dissipation component. The first surface further includes a raised area in at least a portion of the region of the first surface, wherein the raised area comprises a first portion providing a target for application of, or proper positioning of, a the thermally conductive substance, e.g., a thermal putty. In an exemplary embodiment such as that shown in Figure 6, view 410 illustrates an arrangement of features, e.g., a raised area or a plurality of raised features in an area of PCB 120 such as features 330 in a portion of area 320 as shown in Figure 3. In addition, the exemplary raised area in view 410 further includes feature 460 comprising a crossed pair of features, e.g., crossed raised lines or traces, forming an "X" pattern in the approximate center of the region or the raised area. Feature 460 is configured to provide a target for application of the thermally conductive substance. That is, placement of a small portion or pellet of thermally conductive substance on target 460 will approximately center the substance in the area intended to form a thermal interface and increase the likelihood that the substance, e.g., a thermal putty, will properly spread through the thermal interface area as intended when the interface is assembled to ensure efficient heat transfer through the thermal interface region. A target such as target 460 may be incorporated in any of the patterns of features used to decrease thermal compound migration as shown in the various views of Figure 6. It should be apparent that although target 460 is shown in each of the views in Figure 6, a target is not required and may be included or not as appropriate for a particular application of the present principles.

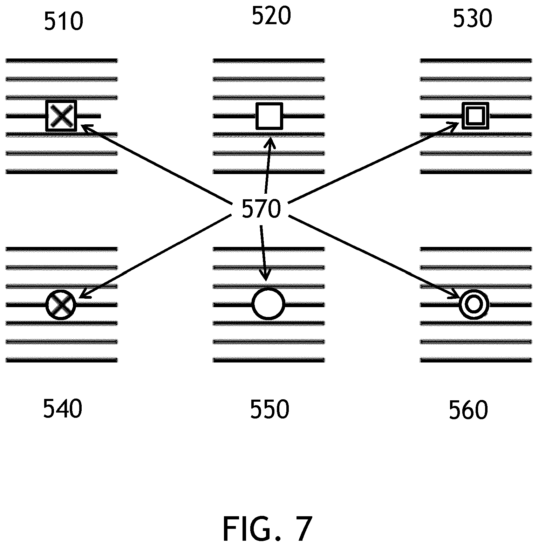

Also, various embodiments of a target for application of a substance such as thermal putty are possible in accordance with the present principles. As shown in Figure 7, and in accordance with the present principles a target may take various forms other than cross 460 shown in Figure 4 such as the exemplary embodiments 570 in views 510 through 560 of Figure 7, e.g., a cross inside a rectangle such as in view 510, a rectangle such as in view 520, a plurality of nested rectangles such as in view 530, a cross inside a circle such as in view 540, a circle such as in view 550, or a plurality of nested circles such as in view 560.

In accordance with another aspect of the present principles, in the exemplary embodiment depicted in Figure 3, region or area 320 and features 330 are shown to occupy a portion of planar surface 170 of PCB 120 and region 320 may be increased or reduced in area to occupy more or less of surface 170 than that depicted in Figure 3. In accordance with another aspect of the present principles, various characteristics of features 330 may be varied to control parameters such as heat conduction efficiency in the thermal interface. For example, the density of features 330 in the area of surface 170 occupied by features 330 may be varied by increasing or decreasing the number of ridges, traces or raised areas in a particular area. Also, the width of a particular feature or features or trace or traces and/or the spacing between features may be increased or decreased. For example, the width of a trace or traces may be greater than or less than the space between adjacent traces. As a specific example, a width of the traces greater than the width of the spaces between traces causes the surface area occupied by the protruding traces included in features 330 to be greater than 50% of the surface area of PCB 120 occupied by features 330. Also, although the exemplary embodiment of features 330 illustrated in Figure 3 suggests that each feature, e.g., each raised area, ridge or protrusion or space between protrusions, is uniform as to length, width and height, characteristics of the features may vary for one particular feature in a pattern, e.g., one ridge or protrusion may be wider and/or higher and/or longer or shorter than others in a pattern, or may vary throughout a pattern, e.g., each protrusion may have a width and/or depth and/or length different than each of the other protrusions in a pattern. In addition, as mentioned above, the height of the protrusion of one or more of features 330 may be varied. For example, increasing the height of the ridges or protrusions beyond the surface of PCB 120 will increase the surface area in the thermal interface region, thereby improving heat transfer efficiency in the thermal interface.

The present description illustrates the present principles. It will thus be appreciated that those skilled in the art will be able to devise various arrangements that, although not explicitly described or shown herein, embody the present principles and are included within its spirit and scope.

All examples and conditional language recited herein are intended for pedagogical purposes to aid the reader in understanding the present principles and the concepts contributed by the inventor(s) to furthering the art, and are to be construed as being without limitation to such specifically recited examples and conditions. For example, use in the description when referring to the drawings of "top", "bottom", "left", "right" and other such terms indicating an orientation or relative relationship between areas of the Figures are illustrative only and not limiting as to the present principles.

Moreover, all statements herein reciting principles, aspects, and embodiments of the present principles, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

Reference in the specification to "one embodiment" or "an embodiment" of the present principles, as well as other variations thereof, means that a particular feature, structure, characteristic, and so forth described in connection with the embodiment is included in at least one embodiment of the present principles. Thus, the appearances of the phrase "in one embodiment" or "in an embodiment", as well any other variations, appearing in various places throughout the specification are not necessarily all referring to the same embodiment.

Although the illustrative embodiments have been described herein with reference to the accompanying drawings, it is to be understood that the present principles are not limited to those precise embodiments, and that various changes and modifications may be effected therein by one of ordinary skill in the pertinent art without departing from the scope or spirit of the present principles. All such changes and modifications are intended to be included within the scope of the present principles as set forth in the appended claims.

## Claims

1. An electronic device comprising:
a first surface (170) having an area (320) adapted to be thermally coupled to a second surface (160; 260) with a thermally conductive substance (130) included in a region between the first surface and the second surface; and
a pattern of features (330) on a portion of the area (320) of the first surface (170) and configured to impede migration of the thermally conductive substance out of the region.

2. The electronic device of claim 1 wherein:
the first surface comprises a surface (170) of a printed circuit board (120) included in the electronic device; and
the second surface comprises a surface of a component (110; 210) included in the electronic device, wherein themal coupling of the first surface to the second surface dissipates heat from the printed circuit board to the component.

3. The electronic device of claim 1 or 2 wherein the pattern of features comprises a feature (460) centered in the portion (320) of the surface (170) of the printed circuit board (120) and providing a target facilitating a procedure included in thermally coupling the second surface (160; 260) of the component (110; 210) to the surface (170) of the printed circuit board.

4. The electronic device of claim 3 wherein the thermally conductive substance (130) comprises a thermal putty, and the procedure comprises application of the thermal putty, and the target comprises a target for application of the putty.

5. The electronic device of claim 1 or 2 wherein the pattern of features (330) includes a raised area in the portion of the area (320) and protruding from the first surface (170) into the region between the first surface and the second surface; wherein
the raised area comprises a portion (460) providing a target for application of the thermally conductive substance.

6. The electronic device of claim 5 wherein the thermally conductive substance comprises a thermal putty.

7. The electronic device of claim 2 combined with any one of claims 3 to 6 wherein the pattern of features comprises an arrangement of a plurality of ridges (330) protruding from the surface of the printed circuit board (120) into the region.

8. The electronic device of claim 7 wherein the plurality of ridges includes a plurality of copper traces on the surface of the printed circuit board and the arrangement comprises at least one of the plurality of ridges being positioned perpendicular to a direction of migration of the thermal putty.

9. The electronic device of claim 7 or 8 wherein the arrangement of the plurality of ridges comprises a positioning of the plurality of ridges in at least one of a plurality of parallel ridges (410) and a rectangular grid (420) and a starburst (450) and a spiral (470) and a plurality of crossed ridges (430) and a plurality of circles (440).

10. The electronic device of any one of claims 7 to 9 wherein the plurality of ridges occupies less than 50% of the surface area of the region.

11. The electronic device of any one of claims 7 to 10 wherein the plurality of ridges are formed in the region of the surface of the printed circuit board by one of screened and reflowed solder and wave applied solder.

12. The electronic device of any one of claims 7 to 11 wherein the plurality of ridges formed in the region of the printed circuit board are configured to increase a surface area of the region of the surface of the printed circuit board thermally coupled to the surface of the component, thereby improving a thermal conduction of the thermal coupling between the surface of the printed circuit board and the surface of the component.

13. The electronic device of claim 2 combined with the features of any one of claims 3-12 wherein the component comprises one of a heat spreader (110) and a heat sink (210).

14. The electronic device of any of the preceding claims wherein the pattern of features is configured for at least one of surrounding or encapsulating or enclosing or retaining the thermally conductive substance.

15. An electronic device according to any of the preceding claims wherein the electronic device comprises one of a set top box, a gateway device, a router, a computer, and a digital television.
